Europäisches Patentamt

**European Patent Office**

**Office européen des brevets**

(19)

(11) Veröffentlichungsnummer : **0 002 648**
**B2**

(12) # NEUE EUROPÄISCHE PATENTSCHRIFT

(45) Veröffentlichungstag der neuen Patentschrift :
09.11.88

(21) Anmeldenummer : 78810030.3

(22) Anmeldetag : 12.12.78

(51) Int. Cl.⁴ : **G 04 F  1/00, H 03 K  17/28,**
**H 01 H  47/18**

(54) **Treppenlicht-Zeitschalter.**

(30) Priorität : 16.12.77 CH 15482/77

(43) Veröffentlichungstag der Anmeldung :
27.06.79 Patentblatt 79/13

(45) Bekanntmachung des Hinweises auf die Patenterteilung : 22.07.81 Patentblatt 81/29

(45) Bekanntmachung des Hinweises auf die Entscheidung
über den Einspruch : 09.11.88 Patentblatt 88/45

(84) Benannte Vertragsstaaten :
BE DE FR IT SE

(56) Entgegenhaltungen :
DE-B- 1 665 985
DE-B- 2 243 799
DE-C- 1 765 817
US-A- 4 012 673
"Elektronische Zeitrelais und ihre Anwendung in der
Praxis" - Der Elektromeister + Deutsches Elektrohandwerk/de, Heft 21/1973
McMOS Low-Power Programmable Timer" - Firmen-
Druckschrift MC 14536-DS 9297R1 - Motorola Semiconductor Products Inc. 1975
"SAJ 341 - ein programmierbarer MOS-Universalbaustein für Zähler- und Uhrenanwendungen "-Sie-
mens-Bauteile report 13 (1975) Heft 2
"7.2. Universeller Zeit- und Zählerbaustein SAJ 341"-
Siemens- Schaltbeispiele 1974/75
ITT Sonderdruck 1975 / Günter Peltz: Langzeitgeber
mit Zeitvervielfacher, Funkschau 1974 Heft 23, pp.
901-905, Heft 24, pp. 959-960

(73) Patentinhaber : LGZ LANDIS & GYR ZUG AG
Gubelstrasse 22
CH-6301 Zug (CH)

(72) Erfinder : Petzold, Hartmut
Am Kreuzstein 51
D-6457 Maintal 2 (DE)
Erfinder : Andersen, Niels-Thorup
Augustusstrasse 10
D-6000 Frankfurt a.M. 50 (DE)

(74) Vertreter : Steiner, Martin et al
c/o AMMANN PATENTANWAELTE AG BERN
Schwarztorstrasse 31
CH-3001 Bern (CH)

## Beschreibung

Die vorliegende Erfindung betrifft einen Treppenlicht-Zeitschalter gemäss Oberbegriff der Patentansprüche 1 bzw. 2.

Aus der DE-C-1 765 817 ist ein derartiger Treppenlicht-Zeitschalter zum direkten Netzanschluss mit einer gemeinsamen Ein- und Nachschaltleitung und einem Remanenzrelais bekannt, das sich mittels Lichtdruckknopf einschalten lässt und das infolge der Remanenzwirkung in der Einschaltstellung verbleibt bis die auf Grund eines RC-Gliedes verzögert ansteigende Spannung an einer Schaltdiode den Wert der Zündspannung der Schaltdiode erreicht, welche dann einen Gegenimpuls erzeugt, der den Abfall des Remanenzrelais bewirkt. Ein solcher Treppenlicht-Zeitschalter arbeitet jedoch auf analoge Weise und er kann infolgedessen keine genauen und langen Verzögerungszeiten bemessen.

Es ist daher Aufgabe vorliegender Erfindung einen Treppenlicht-Zeitschalter zum direkten Netzanschluss zu schaffen, der in einfacher Weise die Vorteile des bekannten Schalters übernimmt, indem er über eine gemeinsame, direkt an einen Netzleiter schaltbare, Ein- und Nachschaltleitung beliebig oft rückschaltbar ist und dabei zur elektronischen Bestimmung beliebig langer Zeitabschnitte mittels Generator und Frequenzteiler ausgeführt ist, womit ein Automat sehr kleiner Abmessungen bei hoher Zuverlässigkeit und Genauigkeit geschaffen ist.

Erfindungsgemässe Lösungen dieser Aufgabe sind im Kennzeichen der Patentansprüche 1 und 2 beschrieben.

Es ist zwar an sich auch bekannt, als zeitbestimmendes Glied einen elektronischen Generator vorzusehen, dessen Periode kürzer ist als die zu bemessenden Zeitabschnitte und die Frequenz des Generators in einem rückstellbaren elektronischen Frequenzteiler zu teilen (« Elektronische Zeitrelais und ihre Anwendung in der Praxis », Der Elektromeister + Deutsches Elektrohandwerk/de, Heft 21, 1973, Seiten 1 bis 5). Dabei werden aber der Generator und der Frequenzteiler nicht direkt vom Netz gespeist und das zeitbestimmende Glied ist nicht über eine gemeinsame Ein- und Nachschaltleitung über Schalter mit einem Netzleiter verbindbar.

Die Erfindung wird nun anhand zweier Anwendungsbeispiele der Schaltung in Treppenhausautomaten erläutert.

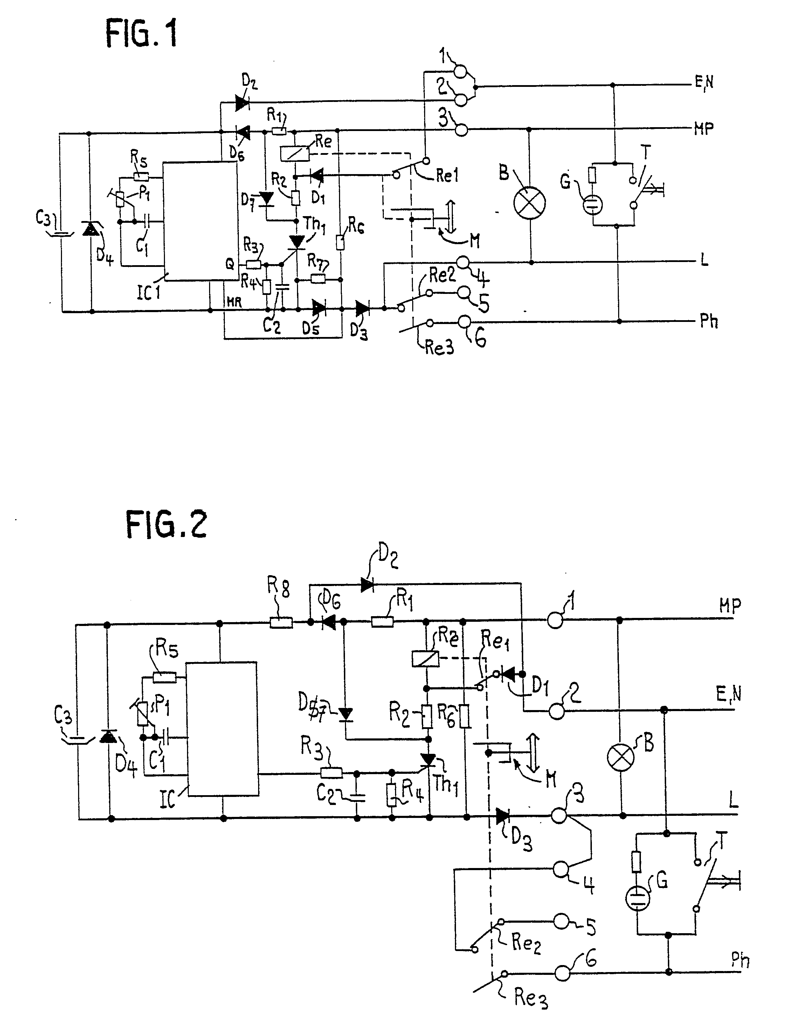

Figuren 1 und 2 zeigen je die vollständige Schaltung mit vier Anschlußleitern, wobei eine Rückstellung aus jedem beliebigen Zustand möglich ist.

Die in Figur 1 dargestellte Schaltung weist Anschlußklemmen 1 bis 6 auf, von welchen die Klemmen 1 und 2 mit einem Einschalt- und Nachschaltleiter E, N, die Klemme 3 mit einem Mittelpunktsleiter MP, die Klemme 4 mit einem Lastleiter L und die Klemme 6 mit dem Phasenleiter Ph des Netzes verbunden sind. Die Klemme 5 ist mit einem Ruhekontakt Re2 verbunden und kann in nicht dargestellter Weise mit einer Schaltuhr verbunden sein, um im Ausschaltzustand des Automaten mindestens eine zwischen die Leiter L und MP geschaltete Beleuchtungslampe B zu speisen. Zwischen die Phasenleitung Ph und die Einschaltleitung E, N ist eine Glimmlampe G mit Vorwiderstand sowie ein Einschalter T geschaltet. In üblicher Weise können an mehreren Stellen durch Glimmlampen G beleuchtete einschalter T vorgesehen sein.

Die eigentliche Schaltung weist ein Remanenzrelais oder Haftrelais Re auf, das Ruhekontakte Re1 und Re2 sowie einen Arbeitskontakt Re3 aufweist. Der Ruhekontakt Re1 ist über eine Diode $D_1$ mit der einen Seite der Wicklung des Relais Re verbunden, auf welcher Seite ebenfalls ein Widerstand $R_2$ und ein Thyristor $Th_1$ angeschlossen sind. Die andere Seite der Relaiswicklung ist einerseits mit der Klemme 3 und andererseits mit dem Widerstand $R_1$ verbunden. Die Widerstände $R_1$, $R_2$ und die Relaiswicklung werden durch eine Diode $D_7$ überbrückt. Über den Widerstand $R_1$ und Dioden $D_2$ und $D_6$ ist das Relais ferner mit der Klemme 2 verbunden. Die Verbindungsstelle zwischen den Dioden $D_6$ und $D_2$ ist mit Speiseeingängen einer integrierten Schaltung IC1 verbunden, welche einen RC-Oszillator und einen Frequenzteiler bzw. Zähler einschließt. Die frequenzbestimmenden Elemente $C_1$, $R_5$ und ein Einstellpotentiometer $P_1$ des Oszillators sind separat herausgezeichnet. Die Speisespannung des integrierten Stromkreises IC1 wird durch einen Kondensator $C_3$ geglättet und durch eine Zenerdiode $D_4$ geregelt. Der Ausgang Q der integrierten Schaltung IC1 steuert über einen Widerstand $R_3$ den Thyristor Th1, mit dessen Steuerelektrode ein Kondensator C2 und ein Widerstand $R_4$ verbunden sind. Der Thyristor Th1 ist über Dioden $D_3$ und $D_5$ mit der Lastleitung L verbunden. Widerstände $R_6$ und $R_7$ verbinden die Kontaktstelle zwischen den Dioden $D_3$ und $D_5$ mit der Mittelpunktleitung MP bzw. der Kathode des Thyristors Th1, und diese Kontaktstelle ist ebenfalls mit einem Rückstelleingang MR der integrierten Schaltung IC1 verbunden.

Im dargestellten Ruhezustand ist das Relais Re abgefallen, in welchem Falle die Kontakte Re1 und Re2 geschlossen sind. Über die Glimmlampe oder Glimmlampen G fließt ein kleiner Strom von der Phasenleitung Ph zur Einschalt- und Nachschaltleitung E, N über den Relaiskontakt Re1, die Diode $D_1$ und das Relais Re zur Mittelpunktslinie MP. Das Relais Re ist so zu bemessen, daß es beim gesamten Strom der Glimmlampen G sicher nicht anzieht. Das kann durch eine entsprechende Auslegung dieses Relais mit entsprechender Feder erreicht werden.

Zur Einschaltung wird in üblicher Weise einer der Schalter oder Taster T geschlossen, wodurch die volle Phasenspannung von der Leitung Ph an die Einschalt- und Nachschaltleitung E, N angelegt wird. Es fließt damit ein Strom über den Schalter T, den Ruhekontakt Re1, die Diode $D_1$ und das Relais Re zur Mittelpunktleitung Mp. Damit zieht das Relais Re an und unterbricht am Kontakt Re1 seinen Einschaltstromkreis. Das Relais bleibt infolge seiner eigenen Remanenz haften. Es ist somit möglich, dieses Relais außerordentlich klein zu bemessen, weil es nur gerade zur Einschaltung von einem erheblichen Strom durchflossen sein muß, während üblicherweise nur der sehr schwache Glimmlampenstrom fließt, durch welchen das Relais kaum erwärmt wird. Durch das Anziehen des Relais ist der Arbeitskontakt Re3 geschlossen worden, womit die Beleuchtungslampen B über diesen Kontakt gespeist werden. Zugleich liegt nun die Spannung an den Dioden $D_6$, $D_5$ und $D_3$, wodurch der Kondensator $C_3$ aufgeladen wird. Beim Erreichen einer bestimmten Speisespannung beginnt der Oszillator der integrierten Schaltung IC1 zu schwingen. Der Ausgang Q des Zählers dieser Schaltung bleibt jedoch vorderhand auf Null, bis eine bestimmte Anzahl von Oszillatorschwingungen ausgezählt sind. Diese Zahl hängt von der Zahl von Teilerstufen ab. Die Frequenz des Oszillators kann mittels des Potentiometers $P_1$ eingestellt werden, und es könnten zusätzlich bestimmte Teilerstufen überbrückt werden, um in dieser Weise die üblicherweise zu bemessende Zeitspanne vorzuwählen. Nach Ablauf dieser Zeitspanne geht der Ausgang Q vom Potential 0 auf das Potential 1, womit der Thyristor $Th_1$ leitend wird und damit ein Stromweg von der Mittelpunktleitung MP über das Relais Re, den Widerstand $R_2$, den Thyristor $Th_1$ und die Dioden $D_5$ und $D_3$ zur Phasenleitung Ph hergestellt wird. Es fließt hierbei durch das Relais Re ein Strom in umgekehrter Richtung des Einschaltstromes, welcher Strom durch den Widerstand $R_2$ auf einen solchen Wert begrenzt wird, daß die Remanenz des Spulenkerns des Relais so weit aufgehoben wird, daß das Relais abfällt. Damit unterbricht der Relaiskontakt Re3 die Speisung der Beleuchtungslampen B und auch die Speisung der Elektronik. Fällt hierbei die Speisespannung unter einen bestimmten Pegel, so wird der Zähler der integrierten Schaltung IC1 automatisch auf 0 zurückgestellt und ist damit für eine neue Auszählung bzw. Messung einer Zeitspanne bereit.

Wird während des Auszählens der vorgegebenen Anzahl von Oszillatorschwingungen der Schalter T wieder geschlossen, wird die positive Elektrode des Ladekondensators $C_3$ über den Schalter T und die Diode $D_2$ mit der Phasenspannung der Leitung Ph verbunden. Die negative Elektrode des Ladekondensators wird hiermit auf eine Spannung gebracht, die etwa um 12 Volt unterhalb derjenigen des Phasenleiters Ph liegt. Wenn nun der Mittelpunktsleiter Mp bei einer negativen Halbwelle der Sinusspannung am Phasenleiter Ph gegenüber demselben positiv wird, entsteht eine Spannungsdifferenz zwischen dem Mittelpunktsleiter MP und der Minusseite des Ladekondensators $C_3$. Diese Spannungsdifferenz wird in einem Verhältnis von ungefähr 1 : 11 geteilt durch die Widerstände $R_6$ und $R_7$, dem

Rückstelleingang MR der integrierten Schaltung IC1 zugeführt. Wenn die Spannung an der Verbindungsstelle der Widerstände $R_6$ und $R_7$ in der genannten Sinushalbwelle die Spannung des Ladekondensators bzw. der Phasenleitung Ph übersteigen will, wird die Spannung durch $D_3$ auf dem Potential der Phasenleitung Ph gehalten und somit auch auf das Potential der positiven Seite des Ladekondensators $C_3$ begrenzt. Am Eingang MR der integrierten Schaltung erscheint somit eine Impulsreihe im Takt der sinusförmigen Netzspannung bis die Ladung auf dem Ladekondensator von der integrierten Schaltung aufgebraucht ist, sofern der Schalter T überhaupt solange betätigt wird. Die zur Rückschaltung der integrierten Schaltung bzw. deren Teiler erforderliche längste Schalterbetätigung beträgt somit bei einer Netzfrequenz von 50 Hz 20 ms. Beim Loslassen des Schalters T läuft die Zeitbemessung wieder von vorne wie oben beschrieben. Durch Nachschalten kann somit die bemessene Zeitspanne verlängert werden.

In Figur 1 ist schematisch eine mechanische Umschaltvorrichtung M angedeutet, welche es gestattet, die Relaiskontakte dauernd in der dargestellten Ruhelage zu blockieren oder aber dauernd umzuschalten und damit Dauerbeleuchtung zu ermöglichen, während in einer dritten Stellung das Relais für die beschriebene Arbeitsweise freigegeben wird.

Abgesehen von den bereits erwähnten Vorteilen, die hauptsächlich im gesamthaft kleinen Bauvolumen zu sehen sind, ist besonders darauf hinzuweisen, daß praktisch beliebig lange Verzögerungszeiten bei verhältnismäßig genauer Zeitbestimmung bis zu Stunden möglich sind. Die Schaltung kann direkt mit der Netzspannung ohne galvanische Trennung betrieben werden. Es wird eine direkte Ansteuerung eines Thyristors möglich, der Netzspannung schaltet. Die Schaltung braucht wenig Strom, da kein Haltestrom für das Relais erforderlich ist.

In Figur 2 sind entsprechende Elemente gleich bezeichnet wie in Fig. 1 und werden nicht mehr erklärt. Die wesentlichen Unterschiede zwischen der Schaltung nach Fig. 2 gegenüber derjenigen nach Fig. 1 bestehen darin, daß anstelle der Klemmen 1 und 2 die Klemmen 3 und 4 miteinander verbunden sind, und daß die Leiter MP, E/N, L und Ph entsprechend etwas anders angeschlossen sind. Ferner fällt der Rückstellstromkreis und damit die Diode D5 weg. Es ist zusätzlich ein Widerstand R8 vorgesehen.

Wird während des Zeitblaufs der Einschalter T erneut betätigt, so wird die Plusseite des Ladekondensators $C_3$ über $D_2$ und T mit der Phase Ph verbunden. Die negative Klemme des Ladekondensators $C_3$ liegt somit auf einer Spannung unterhalb der Phasenspannung. Wird nun der Mittelpunktsleiter MP während einer negativen Halbwelle der Phasenspannung gegenüber derselben positiv, fließt ein Entladestrom über $R_6$, $C_3$, $R_8$, $D_2$ und T zur Phase. Hierdurch wird $C_3$ allmählich entladen, und eine Rückstellung tritt in der oben bereits erwähnten Weise ein, wenn die Versorgungsspannung auf etwa 5 V gesunken ist. Bei einer ausgeführten Schaltung beträgt die Zeit bis zur Rückstellung etwa 150 ms, doch kann diese Zeit durch entsprechende Wahl der Widerstände $R_6$ und $R_8$ auch etwas kürzer bemessen werden.

**Patentansprüche**

1. Treppenlicht-Zeitschalter mit
— einem zeitbestimmenden elektronischen Glied (IC, C1, P1, R5) zur Festlegung eines wählbaren, zu bemessenden Zeitabschnitts,
— Netzanschlussklemmen (1, 6) zum Anschluss an den Mittelpunktsleiter (MP) sowie den Phasenleiter (Ph),
— einer Ein- und Nachschaltklemme (2) zum Anschluss an einen Ein- und Nachschaltleiter (E, N), der über einen jeden von mehreren Tast-Schaltern (T) mit dem Phasenleiter (Ph) verbindbar ist,
— einer Klemme (3) zum Anschluss an einen Lastleiter (L) für einen Verbraucherkreis (B), welcher zwischen dem Mittelpunktsleiter (MP) und dem Lastleiter (L) verbunden ist, wobei der Lastleiter mit dem Phasenleiter (Ph) verbindbar ist,
— einem Remanenzrelais (Re) zum Ein- und Ausschalten des Verbraucherkreises (B),
— einem Einschaltkreis (D1, Re1) zur Beaufschlagung des Remanenzrelais (Re) mit einem gleichgerichteten Einschaltstrom, welcher im geschlossenen Zustand eines der Tast-Schalter (T) über die Ein- und Nachschaltklemme (2) geliefert wird,
— einem von dem zeitbestimmenden elektronischen Glied (IC, C1, P1, R5) gesteuerten Ausschaltkreis (Th1, R2) zur Beaufschlagung des Remanenzrelais zu einem von dem elektronischen Glied bestimmten Zeitpunkt mit einem gleichgerichteten Ausschaltstrom,
— Rückstelleinrichtungen zum Rücksetzen des zeitbestimmenden elektronischen Glieds über den Ein- und Nachschaltleiter (E, N) aus jedem Stadium des Zeitabschnitts durch Betätigung eines der Tast-Schalter (T), dadurch gekennzeichnet, dass
— das Remanenzrelais (Re) Mittel (Re1) aufweist, welche unmittelbar nach dem Anziehen des Remanenzrelais seinen Einschaltkreis (D1, Re1) unterbrechen,
— das zeitbestimmende elektronische Glied (IC, C1, P1, R5) einen Oszillator, dessen Periode kürzer als der vorgewählte, zu bemessende Zeitabschnitt ist, und einen rückstellbaren Frequenzteiler aufweist,
— ein Speisestromkreis (R1, D6, R8, C3, D4, D3), welcher eine Versorgungspannung für das zeitbestimmende elektronische Glied (IC, C1, P1, R5) liefert, vorgesehen ist, der einen nach Anziehen des Remanenzrelais (Re) durch Betätigung eines der Tast-Schalter (T) über einen Kontakt (Re3) des Remanenzrelais (Re) und Gleichrichterelemente (D3, D6) zwischen die Netzanschlussklemmen (1, 6) gelegten Ladekondensator (C3) umfasst,
— der Frequenzteiler durch Verringerung seiner Versorgungsspannung rücksetzbar ist,
— die Rückstelleinrichtungen einen Entladestromkreis (R6, R8, D2) für den Ladekondensator (C3) aufweisen, über den der Ladekondensator einerseits über eine Diode (D2) mit der Ein- und Nachschaltklemme (2) und andererseits über einen Widerstand (R6) mit der Netzanschlussklemme (1) für den Mittelpunktsleiter (MP) verbunden ist, derart, dass bei Betätigung eines der Tast-Schalter (T) während der Aktivierungsdauer des Remanenzrelais (Re) durch Entladung die Spannung am Ladekondensator (C3) verringert und dadurch der Frequenzteiler zurückgesetzt wird (Fig. 2).

2. Treppenlicht-Zeitschalter mit
— einem zeitbestimmenden elektronischen Glied (IC1, C1, P1, R5) zur Festlegung eines wählbaren, zu bemessenden Zeitabschnitts,
— Netzanschlussklemmen (3, 6) zum Anschluss an den Mittelpunktsleiter (MP) sowie den Phasenleiter (Ph),
— einer Ein- und Nachschaltklemme (2) zum Anschluss an einen Ein- und Nachschaltleiter (E, N), der über einen jeden von mehreren Tast-Schaltern (T) mit dem Phasenleiter (Ph) verbindbar ist,
— einer Klemme (4) zum Anschluss an einen Lastleiter (L) für einen Verbraucherkreis (B), welcher zwischen dem Mittelpunktsleiter (MP) und dem Lastleiter (L) verbunden ist, wobei der Lastleiter mit dem Phasenleiter (Ph) verbindbar ist,
— einem Remanenzrelais (Re) zum Ein- und Ausschalten des Verbraucherkreises (B),
— einem Einschaltkreis (D1, Re1) zur Beaufschlagung des Remanenzrelais (Re) mit einem gleichgerichteten Einschaltstrom, welcher im geschlossenen Zustand eines der Tast-Schalter (T) über die Ein- und Nachschaltklemme (2) geliefert ist,
— einem von dem zeitbestimmenden elektronischen Glied (IC1, C1, P1, R5) gesteuerten Ausschaltkreis (Th1, R2) zur Beaufschlagung des Remanenzrelais zu einem von dem elektronischen Glied bestimmten Zeitpunkt mit einem gleichgerichteten Ausschaltstrom,
— Rückstelleinrichtungen zum Rücksetzen des zeitbestimmenden elektronischen Glieds über den Ein- und Nachschaltleiter (E, N) aus jedem Stadium des Zeitabschnitts durch Betätigung eines der Tast-Schalter (T), dadurch gekennzeichnet, dass
— das Remanenzrelais (Re) Mittel (Re1) aufweist, welche unmittelbar nach dem Anziehen des Remanenzrelais seinen Einschaltkreis (D1, Re1) unterbrechen,
— das zeitbestimmende elektronische Glied (IC1, C1, P1, R5) einen Oszillator, dessen Periode kürzer als der vorgewählte, zu bemessende Zeitabschnitt ist, und einen mit einem Impulsrücksetzeingang ausgestatteten Frequenzteiler aufweist,
— ein Speisestromkreis (R1, D6, C3, D4, D5, D3), welcher eine Versorgungspannung für das zeitbestimmende elektronische Glied (IC1, C1, P1, R5) liefert, vorgesehen ist, der einen nach Anziehen des Remanenzrelais (Re) durch Betätigung eines der Tast-Schalter (T) über einen Kontakt (Re3) des Remanenzrelais (Re) und Gleichrichterelemente (D3, D5, D6) zwischen die Netzanschlussklemmen (3, 6) gelegten Ladekondensator (C3) umfasst,

— die Rückstelleinrichtungen folgende Elemente aufweisen

— eine erste Gleichrichterdiode (D2), die die Ein- und Nachschaltklemme (2) mit dem dem Mittelpunktsleiter (MP) zugeordneten Anschluss des Ladekondensators (C3) verbindet, und einen zwischen den dem Phasenleiter (Ph) zugeordneten Anschluss des Ladekondensators (C3) und die Netzanschlussklemme (3) für den Mittelpunktsleiter (MP) gelegten Spannungsteiler (R6, R7), dessen Abgriff ebenso wie der Impulsrücksetzeingang (MR) des Frequenzteilers über eine zweite Gleichrichterdiode (D3) an die Netzanschlussklemme (6) für den Phasenleiter (Ph) gelegt ist, wobei bei Betätigung eines der Tast-Schalter (T) der dem Mittelpunktsleiter (MP) zugeordnete Anschluss des Ladekondensators (C3) auf das Phasenpotential und die andere Seite des Ladekondensators auf ein Potential, das um die Zener-Spannung einer parallel zum Ladekondensator geschalteten Zenerdiode (D4) kleiner als das Phasenpotential ist, gebracht wird, wodurch die vom Abgriff des Spannungsteilers (R6, R7) gelieferten Rücksetzimpulse an den Rücksetzeingang des Frequenzteilers gelangen (Fig. 1).

3. Treppenlicht-Zeitschalter nach Anspruch 1 oder 2 dadurch gekennzeichnet, dass der Speisestromkreis (R1, D6, C3, D4, D3; R1, D6, C3, D4, D5, D3) zwischen die Netzanschlussklemme (1;3) für den Mittelpunktsleiter (MP) und die Anschlussklemme (3;4) für den Verbraucherkreis (L) geschaltet und durch einen Arbeitskontakt (Re3) des Remanenzrelais (Re) einschaltbar ist.

4. Treppenlicht-Zeitschalter nach Anspruch 1 oder 2, dadurch gekennzeichnet, dass im Ausschaltkreis (Th1, R2) ein durch den Ausgang (Q) des zeitbestimmenden elektronischen Glieds steuerbarer Thyristor (Th1) liegt, welcher in Reihe mit einem Begrenzungswiderstand (R2) geschaltet ist.

**Claims**

1. A stairway light time switch with
— an electronic time determining element (IC, C1, P1, R5) for defining an adjustable time interval to be measured,
— main circuit connecting terminals (1, 6) for connecting to the neutral conductor (MP) as well as to the phase conductor (Ph),
— a switching in and prolongation of switching in terminal (2) for connection to a switching in and prolongation of switching in conductor (E, N) capable to be connected with the phase conductor (Ph) by each switch of a plurality of key switches (T),

— a terminal (3) for connection to a load conductor (L) for a load circuit (B) connected between the neutral conductor (MP) and the load conductor (L), the load conductor being capable to be connected to the phase conductor (Ph),
— a remanence relay (Re) for switching in and out the load circuit (B),
— a switching in circuit (D1, Re1) for supplying the remanence relay (Re) with a rectified switching in current which, in the closed condition of one of the key switches (T), is delivered by the switching in and prolongation of switching in terminal (2),
— a switching out circuit (Th1, R2) controlled by the electronic time determining element (IC, C1, P1, R5) for supplying the remanence relay with a rectified switching out current at an instant of time determined by the electronic element,
— resetting devices for resetting the electronic time determining element at each state of the interval of time through the switching in and prolongation of switching in conductor (E, N) by actuation of one of the key switches (T), characterized in that
— the remanence relay (Re) comprises means (Re1) which interrupt immediately its switching in circuit (D1, Re1) after the remanence relay has attracted,
— the electronic time determining element (IC, C1, P1, R5) comprises an oscillator the period of which is shorter than the predetermined time interval to be measured and a frequency divider capable to be resetted,
— a supply circuit (R1, D6, R8, C3, D4, D3) which delivers a supply voltage for the electronic time determining element (IC, C1, P1, R5) and which, after the remanence relay (Re) has attracted due to the actuation of one of the key switches (T) and through a contact (Re3) of the remanence relay and rectifier elements (D3, D6), comprises a charging capacitor (C3) disposed between the mains connecting terminals (1, 6),
— the frequency divider is capable to be resetted by reduction of its supply voltage,
— the devices for resetting comprise a discharge circuit (R6, R8, D2) for the charging capacitor (C3) by which the charging capacitor is connected on the one hand by a diode (D2) to the switching in and prolongation of switching in terminal (2) and on the other hand by a resistance (R6) to the mains terminal (1) for the neutral conductor (MP) so that when at the time of actuation of one of the key switches (T) during the duration of activation of the remanence relay (Re), the voltage on the charging capacitor (C3) decreases by discharge which resets the frequency divider (Fig. 2).

2. A stairway light time switch with
— an electronic time determining element (IC1, C1, P1, R5) for defining an adjustable time interval to be measured,
— main circuit connecting terminals (3, 6) for connecting to the neutral conductor (MP) as well as to the phase conductor (Ph),
— a switching in and prolongation of switching in terminal (2) for connection to a switching in and prolongation of switching in conductor (E, N) capable to be connected with the phase conductor (Ph) by each switch of a plurality of key switches (T),

— a terminal (4) for connection to a load conductor (L) for a load circuit (B) connected between the neutral conductor (MP) and the load conductor (L), the load conductor being capable to be connected to the phase conductor (Ph),

— a remanence relay (Re) for switching in and out the load·circuit (B),

— a switching in circuit (D1, Re1) for supplying the remanence relay (Re) with a rectified switching in current which, in the closed condition of one of the key switches (T), is delivered by the switching in and prolongation of switching in terminal (2),

— a switching out circuit (Th1, R2) controlled by the electronic time determining element (IC1, C1, P1, R5) for supplying the remanence relay with a rectified switching out current at an instant of time determined by the electronic element,

— resetting devices for resetting the electronic time determining element at each state of the interval of time through the switching in and prolongation of switching in conductor (E, N) by actuation of one of the key switches (T), characterized in that

— the remanence relay (Re) comprises means (Re1) which interrupt immediately its switching in circuit (D1, Re1) after the remanence relay has attracted,

— the electronic time determining element (IC1, C1, P1, R5) comprises an oscillator the period of which is shorter than the predetermined time interval to be measured and a frequency divider capable to be resetted,

— a supply circuit (R1, D6, R8, C3, D4, D5, D3) which delivers a supply voltage for the electronic time determining element (IC1, C1, P1, R5) and which, after the remanence relay (Re) has attracted due to the actuation of one of the key switches (T) and through a contact (Re3) of the remanence relay and rectifier elements (D3, D5, D6), comprises a charging capacitor (C3) disposed between the mains connecting terminals (3, 6),

— the resetting devices comprise the following elements

— a first rectifier diode (D2) which connects the switching in an prolongation of switching in terminal (2) to the terminal of the charging capacitor (C3) associated to the neutral conductor (MP) and, arranged between the terminal of the charging capacitor (C3) associated to the phase conductor (Ph) and the mains terminal (3) for the neutral conductor (MP), a voltage divider (R6, R7) the output of which as well as the input of the resetting pulses of the frequency divider are connected by a second rectifier diode (D3) to the mains terminal (6) for the phase conductor (Ph), the terminal of the charging capacitor (C3) associated to the neutral conductor (MP) being at the phase potential when one of the key switches (T) is actuated and the other side of the charging capacitor being at a potential which is lower than the phase potential by a Zener voltage of a Zener diode (D4) connected in parallel with the charging capacitor, so that the resetting pulses of the frequency divider are delivered by the output of the voltage divider (R6, R7) to the input for resetting the frequency divider (Fig. 1).

3. A stairway light time switch according to the claim 1 or 2, characterized in that the supply circuit (R1, D6, C3, D4, D3 ; R1, D6, C3, D4, D5, D3) is connected between the mains terminal (1 ; 3) for the neutral conductor (MP) and the connecting terminal (3 ; 4) for the load circuit (B) and that it is capable to be switched in by a make contact (Re3) of the remanence relay (Re).

4. A stairway light time switch according to claim 1 or 2, characterized in that the switching out circuit (Th1, R2) comprises a thyristor (Th1) connected in series with a limiting resistance (R2) and controlled by the output (Q) of the electronic time determining element.

**Revendications**

1. Minuterie pour cage d'escalier avec

— un élément électronique déterminant le temps (IC, C1, P1, R5) pour définir un intervalle de temps réglable à mesurer,

— des bornes de raccordement au réseau (1, 6) pour raccordement au conducteur neutre (MP) ainsi qu'au conducteur de phase (Ph),

— une borne d'enclenchement et de prolongation d'enclenchement (2) pour raccordement à un conducteur d'enclenchement et de prolongation d'enclenchement (E, N) susceptible d'être connecté avec le conducteur de phase (Ph) par chaque interrupteur d'une pluralité d'interrupteurs à touche (T),

— une borne (3) de raccordement à un conducteur de charge (L) pour un circuit d'utilisation (B) connecté entre le conducteur neutre (MP) et le conducteur de charge (L), le conducteur de charge étant susceptible d'être relié au conducteur de phase (Ph),

— un relais à rémanence (Re) pour enclencher et déclencher le circuit d'utilisation (B),

— un circuit d'enclenchement (D1, Re1) pour alimenter le relais à rémanence (Re) avec un courant redressé d'enclenchement qui, en condition fermée de l'un des interrupteurs à touche (T), est délivré par la borne d'enclenchement et de prolongation d'enclenchement (2),

— un circuit· de déclenchement (Th1, R2) commandé par l'élément électronique déterminant le temps (IC, C1, P1, R5) pour alimenter par un courant de déclenchement redressé le relais à rémanence à un instant déterminé par l'élément électronique,

— des dispositifs de remise à l'état initial pour remettre à l'état initial l'élément électronique déterminant le temps par le conducteur d'enclenchement de prolongation d'enclenchement (E, N), à chaque stade de l'intervalle de temps par l'actionnement de l'un des interrupteurs à touche (T), caractérisée en ce que

— le relais à rémanence (Re) comprend des moyens (Re1) qui interrompent immédiatement son circuit d'enclenchement (D1, Re1) après l'attraction du relais à rémanence,

— l'élément électronique déterminant le temps (IC, C1, P1, R5) comprend un oscillateur dont la période est plus courte que l'intervalle de temps prédéterminé à mesurer et un diviseur de fréquence susceptible d'être remis dans son état initial,

— un circuit d'alimentation (R1, D6, R8, C3, D4, D3) qui délivre une tension d'alimentation pour l'élément électronique déterminant le temps (IC, C1, P1, R5) et qui, après l'attraction du relais à rémanence (Re) dû à l'actionnement de l'un des interrupteurs à touche (T) et au travers d'un contact (Re3) du relais à rémanence et des éléments redresseurs (D3, D6), englobe un condensateur de charge (C3) disposé entre les bornes de raccordement au réseau (1, 6),

— le diviseur de fréquence est susceptible d'être remis dans son état initial par réduction de sa tension d'alimentation,

— les dispositifs de remise à l'état initial comprennent un circuit de décharge (R6, R8, D2) pour le condensateur de charge (C3) par lequel le condensateur de charge est connecté d'une part par une diode (D2) avec la borne d'enclenchement et de prolongation d'enclenchement (2) et d'autre part par une résistance (R6) avec la borne du réseau (1) pour le conducteur neutre (MP) de sorte que, lors de l'actionnement de l'un des interrupteurs à touche (T) pendant la durée d'activation du relais à rémanence (Re), la tension sur le condensateur de charge (C3) diminue par décharge et le diviseur de fréquence est remis à l'état initial (fig. 2).

2. Minuterie pour cage d'escalier avec

— un élément électronique déterminant le temps (IC1, C1, P1, R5) pour définir un intervalle de temps réglable à mesurer,

— des bornes de raccordement au réseau (3, 6) pour raccordement au conducteur neutre (MP) ainsi qu'au conducteur de phase (Ph),

— une borne d'enclenchement et de prolongation d'enclenchement (2) pour raccordement à un conducteur d'enclenchement et de prolongation d'enclenchement (E, N) susceptible d'être connecté avec le conducteur de phase (Ph) par chaque interrupteur d'une pluralité d'interrupteurs à touche (T),

— une borne (4) de raccordement à un conducteur de charge (L) pour un circuit d'utilisation (B) connecté entre le conducteur neutre (MP) et le conducteur de charge (L), le conducteur de charge étant susceptible d'être relié au conducteur de phase (Ph),

— un relais à rémanence (Re) pour enclencher et déclencher le circuit d'utilisation (B),

— un circuit d'enclenchement (D1, Re1) pour alimenter le relais à rémanence (Re) avec un courant redressé d'enclenchement qui, en condition fermée de l'un des interrupteurs à touche (T),

est délivré par la borne d'enclenchement et de prolongation d'enclenchement (2),

— un circuit de déclenchement (Th1, R2) commandé par l'élément électronique déterminant le temps (IC1, C1, P1, R5) pour alimenter par un courant de déclenchement redressé le relais à rémanence à un instant déterminé par l'élément électronique,

— des dispositifs de remise à l'état initial pour remettre à l'état initial l'élément électronique déterminant le temps par le conducteur d'enclenchement et de prolongation d'enclenchement (E, N), à chaque stade de l'intervalle de temps par l'actionnement de l'un des interrupteurs à touche (T), caractérisée en ce que

— le relais à rémanence (Re) comprend des moyens (Re1) qui interrompent immédiatement son circuit d'enclenchement (D1, Re1) après l'attraction du relais à rémanence,

— l'élément électronique déterminant le temps (IC1, C1, P1, R5) comprend un oscillateur dont la période est plus courte que l'intervalle de temps prédéterminé à mesurer et un diviseur de fréquence équipé d'une entrée d'impulsions de remise à l'état initial,

— un circuit d'alimentation (R1, D6, R8, C3, D4, D5, D3) qui délivre une tension d'alimentation pour l'élément électronique déterminant le temps (IC1, C1, P1, R5) et qui, après l'attraction du relais à rémanence (Re) dû à l'actionnement de l'un des interrupteurs à touche (T) et au travers d'un contact (Re3) du relais à rémanence et des éléments redresseurs (D3, D5, D6), englobe un condensateur de charge (C3) disposé entre les bornes de raccordement au réseau (3, 6),

— les dispositifs de remise à l'état initial comprennent les éléments suivants

— une première diode de redressement (D2) qui relie la borne d'enclenchement et de prolongation d'enclenchement (2) avec la borne du condensateur de charge (C3) associée au conducteur neutre (MP) et, disposé entre la borne du condensateur de charge (C3) associée au conducteur de phase (Ph) et la borne de réseau (3) pour le conducteur neutre (MP), un diviseur de tension (R6, R7) dont la sortie ainsi que l'entrée d'impulsions de remise à l'état initial du diviseur de fréquence sont reliées par une deuxième diode de redressement (D3) à la borne du réseau (6) pour le conducteur de phase (Ph), la borne du condensateur de charge (C3) associée au conducteur neutre (MP) étant portée au potentiel de phase lors de l'actionnement de l'un des interrupteurs à touche (T) et l'autre côté du condensateur de charge étant porté à un potentiel qui est inférieur au potentiel de phase de la tension de Zener d'une diode Zener (D4) connectée en parallèle sur le condensateur de charge, de sorte que les impulsions de remise à l'état initial du diviseur de fréquence sont délivrées par la sortie du diviseur de tension (R6, R7) à l'entrée de remise à l'état initial du diviseur de fréquence (fig. 1).

3. Minuterie pour cage d'escalier selon la revendication 1 ou 2, caractérisée en ce que le circuit d'alimentation (R1, D6, C3, D4, D3 ; R1, D6, C3, D4, D5, D3) est connecté entre la borne de réseau (1 ; 3) pour le conducteur neutre (MP) et la borne de raccordement (3 ; 4) pour le circuit d'utilisation (L) et qu'il est susceptible d'être enclenché par un contact de travail (Re3) du relais à rémanence (Re).

4. Minuterie pour cage d'escalier selon la revendication 1 ou 2, caractérisée en ce que dans le circuit de déclenchement (Th1, R2) se trouve un thyristor (Th1) connecté en série avec une résistance de limitation (R2) et commandé par la sortie (Q) de l'élément électronique déterminant le temps.

# FIG.1

# FIG.2